# EUROPEAN PATENT APPLICATION

(11) **EP 4 692 982 A1**
(43) Date of publication of application: **11.02.2026**
(21) Application number: 24909540.7
(22) Date of filing: 29.05.2024
(51) Int. Cl.: G06F 1/06, H03K 3/00

(54) **CLOCK GENERATION CIRCUIT AND MEMORY**

(30) Priority: 26.12.2023 CN 202311829264
(71) Applicant: CXMT Corporation, Hefei, Anhui 230601 (CN)
(72) Inventor: YANG, Jun, Hefei, Anhui 230601 (CN); HUANG, Zequn, Hefei, Anhui 230601 (CN)
(74) Representative: Gulde & Partner
(86) International application number: PCT/CN2024/095988
(87) International publication number: WO 2025/138574

(57) **Abstract**

Embodiments of the present disclosure provide a clock generation circuit and a memory. The ith clock generation sub-circuit is configured to: perform sampling processing and latching processing on the ith register input signal based on an inverted clock signal, to generate the ith register signal; and perform first logic processing on the ith register signal and a delayed clock signal, to generate the ith target clock signal. The jth clock generation sub-circuit is configured to: perform sampling processing and latching processing on the (j-1)th register signal based on a preset clock signal, to generate the jth register signal; and perform second logic processing on the jth register signal and the delayed clock signal, to generate the jth target clock signal.

## Description

This application is based on and claims priority of the Chinese Patent Application No. 202311829264.3, filed with China National Intellectual Property Administration on December 26, 2023 and entitled "CLOCK GENERATION CIRCUIT AND MEMORY". The above-referenced application is incorporated herein by reference in its entirety.

### TECHNICAL FIELD

The present disclosure relates to the field of semiconductor technologies, and in particular, to a clock generation circuit and a memory.

### BACKGROUND

For double data transmission, two data transmission clock signals are generated based on one read command, so that two pieces of data can be transmitted in a time in which a single piece of data is originally transmitted, to implement a double data transmission amount. In the prior art, a generation circuit of two data transmission clock signals for transmitting double data needs a relatively large area, wasting circuit resources.

### SUMMARY

Embodiments of the present disclosure provide a clock generation circuit and a memory.

According to a first aspect, an embodiment of the present disclosure provides a clock generation circuit. The clock generation circuit is configured to generate N target clock signals, N is a positive even number, and the clock generation circuit includes N clock generation sub-circuits.

The ith clock generation sub-circuit is configured to: receive the ith register input signal, an inverted clock signal, and a delayed clock signal; perform sampling processing and latching processing on the ith register input signal based on the inverted clock signal, to generate the ith register signal; and perform first logic processing on the ith register signal and the delayed clock signal, to generate the ith target clock signal. i is a positive odd number greater than or equal to 1 and less than N, the ith register input signal is an initial register signal when i=1, and the ith register input signal is the (i-1)th register signal when i>1.

The jth clock generation sub-circuit is configured to: receive the (j-1)th register signal, a preset clock signal, and the delayed clock signal; perform sampling processing and latching processing on the (j-1)th register signal based on the preset clock signal, to generate the jth register signal; and perform second logic processing on the jth register signal and the delayed clock signal, to generate the jth target clock signal. j is a positive even number greater than 1 and less than or equal to N.

The preset clock signal and the inverted clock signal are a pair of inverted signals, and the delayed clock signal is a delayed signal of the preset clock signal.

According to a second aspect, an embodiment of the present disclosure provides a memory. The memory includes at least the clock generation circuit according to any one of the first aspect.

Embodiments of the present disclosure provide a clock generation circuit and a memory. The clock generation circuit is configured to generate N target clock signals, N is a positive even number, and the clock generation circuit includes N clock generation sub-circuits. The ith clock generation sub-circuit is configured to: receive the ith register input signal, an inverted clock signal, and a delayed clock signal; perform sampling processing and latching processing on the ith register input signal based on the inverted clock signal, to generate the ith register signal; and perform first logic processing on the ith register signal and the delayed clock signal, to generate the ith target clock signal. i is a positive odd number greater than or equal to 1 and less than N, the ith register input signal is an initial register signal when i=1, and the ith register input signal is the (i-1)th register signal when i>1. The jth clock generation sub-circuit is configured to: receive the (j-1)th register signal, a preset clock signal, and the delayed clock signal; perform sampling processing and latching processing on the (j-1)th register signal based on the preset clock signal, to generate the jth register signal; and perform second logic processing on the jth register signal and the delayed clock signal, to generate the jth target clock signal. j is a positive even number greater than 1 and less than or equal to N. The preset clock signal and the inverted clock signal are a pair of inverted signals, and the delayed clock signal is a delayed signal of the preset clock signal. In this way, the clock generation circuit generates one group of target clock signals based on an odd-stage clock generation sub-circuit, and generates one group of target clock signals based on an even-stage clock generation sub-circuit, so that two groups of target clock signals can be obtained through only one clock generation circuit, to save circuit resources.

### BRIEF DESCRIPTION OF DRAWINGS

FIG. 1 is a schematic diagram of timing of full data and a clock signal of the full data;
FIG. 2 is a schematic diagram of timing of double data and a clock signal of the double data;
FIG. 3 is a schematic diagram of structural composition of a clock generation circuit;
FIG. 4 is a schematic diagram 1 of structural composition of a clock generation circuit according to an embodiment of the present disclosure;
FIG. 5 is a schematic diagram 2 of structural composition of a clock generation circuit according to an embodiment of the present disclosure;
FIG. 6 is a schematic diagram of structural composition of an initial register signal generation circuit according to an embodiment of the present disclosure;
FIG. 7 is a schematic diagram 3 of structural composition of a clock generation circuit according to an embodiment of the present disclosure;
FIG. 8 is a schematic diagram of structural composition of a signal generation circuit according to an embodiment of the present disclosure;
FIG. 9 is a schematic diagram 1 of timing of a clock generation circuit according to an embodiment of the present disclosure;
FIG. 10 is a schematic diagram 4 of structural composition of a clock generation circuit according to an embodiment of the present disclosure;
FIG. 11 is a schematic diagram 2 of timing of a clock generation circuit according to an embodiment of the present disclosure;
FIG. 12 is a schematic diagram of timing analysis of a clock generation circuit according to an embodiment of the present disclosure;
FIG. 13 is a schematic diagram 5 of structural composition of a clock generation circuit according to an embodiment of the present disclosure; and
FIG. 14 is a schematic diagram of structural composition of a memory according to an embodiment of the present disclosure.

### DESCRIPTION OF EMBODIMENTS

The technical solutions in the embodiments of the present disclosure are clearly and completely described below with reference to the accompanying drawings in the embodiments of the present disclosure. It may be understood that specific embodiments described herein are merely intended to explain related disclosure, but are not intended to limit the present disclosure. In addition, it should be further noted that for ease of description, only a part related to the related disclosure is shown in the accompanying drawings.

Unless otherwise defined, all technical and scientific terms employed in this specification have meanings the same as those commonly understood by a person skilled in the technical field of the present disclosure. The terms employed in this specification are merely intended to describe the embodiments of the present disclosure, but are not intended to limit the present disclosure.

The following descriptions relate to "some embodiments" describing a subset of all possible embodiments. However, it may be understood that "some embodiments" may be the same subset or different subsets of all the possible embodiments, and may be combined with each other when there is no conflict.

It should be noted that the term "first/second/third" in the embodiments of the present disclosure is merely intended to distinguish between similar objects, and does not represent specific sorting for the objects. It may be understood that "first/second/third" may be interchanged for a specific sequence or order if allowed, so that the embodiments of the present disclosure described herein can be implemented in a sequence other than those shown or described herein.

Before the embodiments of the present disclosure are further described in detail, nouns and terms in the embodiments of the present disclosure are first described. The nouns and the terms in the embodiments of the present disclosure are applicable to the following explanations:
static random access memory (Static Random Access Memory, SRAM);
dynamic random access memory (Dynamic Random Access Memory, DRAM);
synchronous dynamic random access memory (Synchronous Dynamic Random Access Memory, SDRAM);
double data rate synchronous dynamic random access memory (Double Data Rate SDRAM, DDR SDRAM);
double data rate (Double Data Rate, DDR);
fifth generation double data rate (Double Data Rate 5, DDR5);
read (Read, RD);
command (Command, CMD);
data (Data, DQ);
full data (Full Data);
double data (Doubling Data);
bit (bit);
data window (Data Window);
first input first output (First Input First Output, FIFO);
column address strobe (Column Address Strobe, CAS);
burst (Burst);
nanosecond (nanosecond, ns);
D flip-flop (Data Flip-Flop or Delay Flip-Flop, DFF);
latch (Latch);
high level (High, H);
low level (Low, L);
gigabyte/GB (Gigabyte/GB, G);
P-type metal oxide semiconductor field effect transistor/P-type transistor (Positive channel Metal Oxide Semiconductor field effect transistor, PMOS transistor); and
N-type metal oxide semiconductor field effect transistor/N-type transistor (Negative channel Metal Oxide Semiconductor field effect transistor, NMOS transistor).

A data bus (Bus) is configured for data transmission, and 1 bit of data or multiple bits of data may be transmitted through one data bus. For example, a read operation is taken as an example. Full data means that 1 bit of data is transmitted through one data bus, and a data window of the data is a time length tCCD between a current read command and a next read command, namely, a time interval between a current CAS command and a next CAS command. However, the full data occupies a channel resource. In other words, a quantity of data buses is too large. In addition, when the full data is stored in a FIFO structure by utilizing a data transmission clock signal, a load (Loading) of the clock signal is very heavy.

Double data is 2 bits of data transmitted through one data bus. For some embodiments, a data window of the 1st bit of data (namely, the 1st burst) of the double data may be 4T, and correspondingly, a data window of the 2nd bit of data (namely, the 2nd burst) is tCCD-4T. A half channel resource may be reduced by utilizing the double data. However, two data transmission clock signals need to be generated based on one read command, to store the double data in the FIFO structure for a subsequent output. Therefore, the load of the data transmission clock signal can be reduced by half. Herein, a relatively short delay time tCCD_S between consecutive read commands may be 8T. A clock cycle of a system clock signal is represented by T.

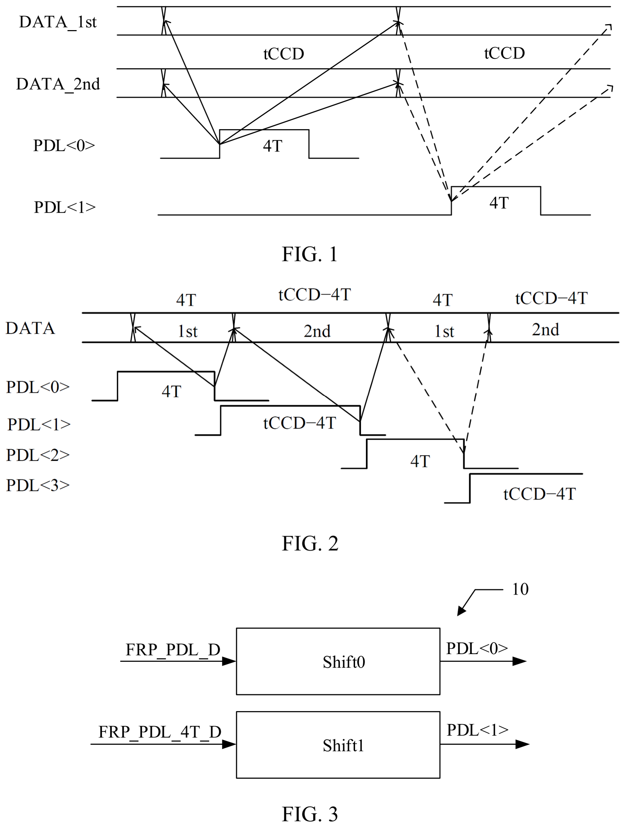

FIG. 1 is a schematic diagram of timing of full data and a clock signal of the full data. As shown in FIG. 1, there are two pieces of full data DATA_1st and DATA_2nd. Both data windows of the full data DATA_1st and DATA_2nd are tCCD. Each burst of the full data is configured to transmit 1 bit of data. There are two data transmission clock signals PDL<0> and PDL<1>. The full data DATA_1st is written into the FIFO structure by utilizing the signal PDL<0>, and the full data DATA_2nd is written into the FIFO structure by utilizing the signal PDL<1>. Herein, the FIFO structure is a D flip-flop, and operates on a rising edge of the data transmission clock signal to write the full data into the FIFO structure.

It should be noted that, for the full data, usually, one data transmission clock signal of the FIFO structure is generated based on one read command, which may be implemented through simple shift processing.

FIG. 2 is a schematic diagram of timing of double data and a clock signal of the double data. As shown in FIG. 2, two adjacent bursts in the double data DATA are configured to transmit 2 bits of data. A data window of the 1st burst of DATA is 4T, a data window of the 2nd burst is tCCD-4T, a data window of the 3rd burst is 4T, and so on. There are two groups of data transmission clock signals. Even-stage signals such as a signal PDL<0> and a signal PDL<2> are a group of data transmission clock signals, and are configured to write a burst whose data window is 4T in the double data DATA into a FIFO structure. Odd-stage signals such as a signal PDL<1> and a signal PDL<3> are a group of data transmission clock signals, and are configured to write a burst whose data window is tCCD-4T in the double data DATA into the FIFO structure. Herein, the FIFO structure is a latch, and the latch has a feature of transmitting data at a high level state and latching data at a low level state. To be specific, when a clock signal received by the latch is at a low level state, an output signal of the latch is an output signal of the latch before the clock signal changes to the low level state; and when the clock signal received by the latch is at a high level state, the output signal of the latch is an input signal of the latch.

It should be noted that for the double data, two data transmission clock signals need to be generated based on one read command. As shown in FIG. 2, the signal PDL<0> and the signal PDL<1> are from the 1st read command, and the signal PDL<2> and the signal PDL<3> are from the 2nd read command. In addition, the signal PDL<0> and the signal PDL<2> can match the corresponding data window 4T in the double data, and the signal PDL<1> and the signal PDL<3> can match the corresponding data window tCCD-4T in the double data.

FIG. 3 is a schematic diagram of structural composition of a clock generation circuit. As shown in FIG. 3, a clock generation circuit 10 includes two groups of shift registers Shift0 and Shift1. The 1st group of shift registers Shift0 are configured to generate even-stage data transmission clock signals such as a signal PDL<0> and a signal PDL<2> based on a signal FRP_PDL_D. The 2nd group of shift registers Shift1 are configured to generate odd-stage data transmission clock signals such as a signal PDL<1> and a signal PDL<3> based on a signal FRP_PDL_4T_D. The signal FRP_PDL_4T_D is a signal obtained by delaying the signal FRP_PDL_D by 4T.

Herein, the two groups of shift registers are usually configured to respectively perform shift processing on the signal FRP_PDL_D whose pulse length is 4T and that is generated based on a read command and the signal FRP_PDL_4T_D obtained by delaying the signal FRP_PDL_D by 4T, to obtain two groups of data transmission clock signals. In this way, the foregoing function of writing double data into a FIFO structure is implemented, and consequently, circuit resources are wasted.

Based on this, the embodiments of the present disclosure provide a clock generation circuit. The clock generation circuit generates one group of target clock signals based on an odd-stage clock generation sub-circuit, and generates one group of target clock signals based on an even-stage clock generation sub-circuit, so that two groups of target clock signals can be obtained through only one clock generation circuit, to implement writing of double data, and save circuit resources.

The following describes the embodiments of the present disclosure in detail with reference to the accompanying drawings.

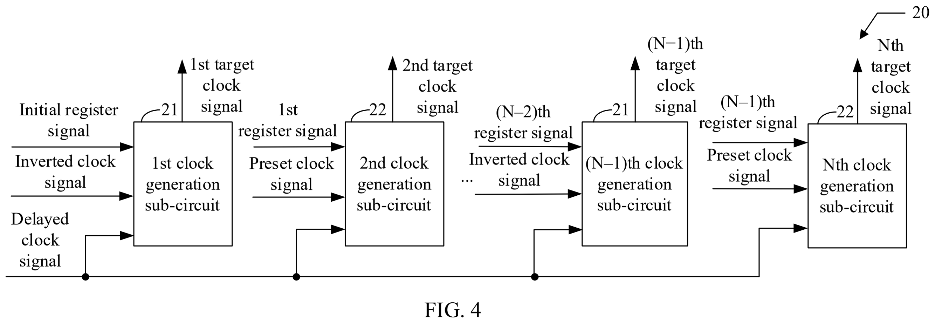

In an embodiment of the present disclosure, FIG. 4 is a schematic diagram 1 of structural composition of a clock generation circuit according to an embodiment of the present disclosure. As shown in FIG. 4, a clock generation circuit 20 is configured to generate N target clock signals. N is a positive even number, and the clock generation circuit 20 includes N clock generation sub-circuits.

The ith clock generation sub-circuit 21 is configured to: receive the ith register input signal, an inverted clock signal, and a delayed clock signal; perform sampling processing and latching processing on the ith register input signal based on the inverted clock signal, to generate the ith register signal; and perform first logic processing on the ith register signal and the delayed clock signal, to generate the ith target clock signal. i is a positive odd number greater than or equal to 1 and less than N, the ith register input signal is an initial register signal when i=1, and the ith register input signal is the (i-1)th register signal when i>1.

The jth clock generation sub-circuit 22 is configured to: receive the (j-1)th register signal, a preset clock signal, and the delayed clock signal; perform sampling processing and latching processing on the (j-1)th register signal based on the preset clock signal, to generate the jth register signal; and perform second logic processing on the jth register signal and the delayed clock signal, to generate the jth target clock signal. j is a positive even number greater than 1 and less than or equal to N.

The preset clock signal and the inverted clock signal are a pair of inverted signals, and the delayed clock signal is a delayed signal of the preset clock signal.

It should be noted that the ith clock generation sub-circuit 21 is an odd-stage clock generation sub-circuit, for example, the 1st clock generation sub-circuit 21, the 3rd clock generation sub-circuit 21, or the 5th clock generation sub-circuit 21. The jth clock generation sub-circuit 22 is an even-stage clock generation sub-circuit, for example, the 2nd clock generation sub-circuit 22, the 4th clock generation sub-circuit 22, or the 6th clock generation sub-circuit 22. For example, FIG. 4 shows only the 1st clock generation sub-circuit 21, the 2nd clock generation sub-circuit 22, ..., the (N-1)th clock generation sub-circuit 21, and the Nth clock generation sub-circuit 22. Another clock generation sub-circuit is not shown. For adaptive understanding, refer to the foregoing text descriptions and FIG. 4.

It should be further noted that when i>1, the (i-1)th register signal is a register signal generated by a previous even-stage clock generation sub-circuit; and the (j-1)th register signal is a register signal generated by a previous odd-stage clock generation sub-circuit.

In this embodiment of the present disclosure, the clock generation circuit 20 is specifically a related circuit for caching data read from a DRAM chip in an integrated circuit design, and in particular, relates to an implementation of a clock generation circuit that writes double data into a FIFO structure in a DDR5 SDRAM chip of a 16 GB capacity. In addition, the clock generation circuit 20 may be applied to a clock generation circuit of a cache for the data read from the DRAM chip. This circuit may be utilized for a clock implementation related to writing the double data into the FIFO structure in another DRAM chip. This is not specifically limited herein.

As shown in FIG. 4, in the clock generation circuit 20, the 1st clock generation sub-circuit 21 generates the 1st target clock signal, the 2nd clock generation sub-circuit 22 generates the 2nd target clock signal, ..., the (N-1)th clock generation sub-circuit 21 generates the (N-1)th target clock signal, and the Nth clock generation sub-circuit 22 generates the Nth target clock signal. In addition, target clock signals generated by an odd-stage clock generation sub-circuit fall into one group, and target clock signals generated by an even-stage clock generation sub-circuit fall into one group. Therefore, only one clock generation circuit may perform one group of shift processing on an initial register signal based on specific logic, to obtain two groups of target clock signals, thereby greatly saving circuit resources.

In some embodiments, the first logic processing is OR logic processing, and the second logic processing is NAND logic processing.

That is, the odd-stage clock generation sub-circuit performs OR logic processing on the ith register signal and the delayed clock signal, to obtain the ith target clock signal; and the even-stage clock generation sub-circuit performs NAND logic processing on the jth register signal and the delayed clock signal, to obtain the jth target clock signal.

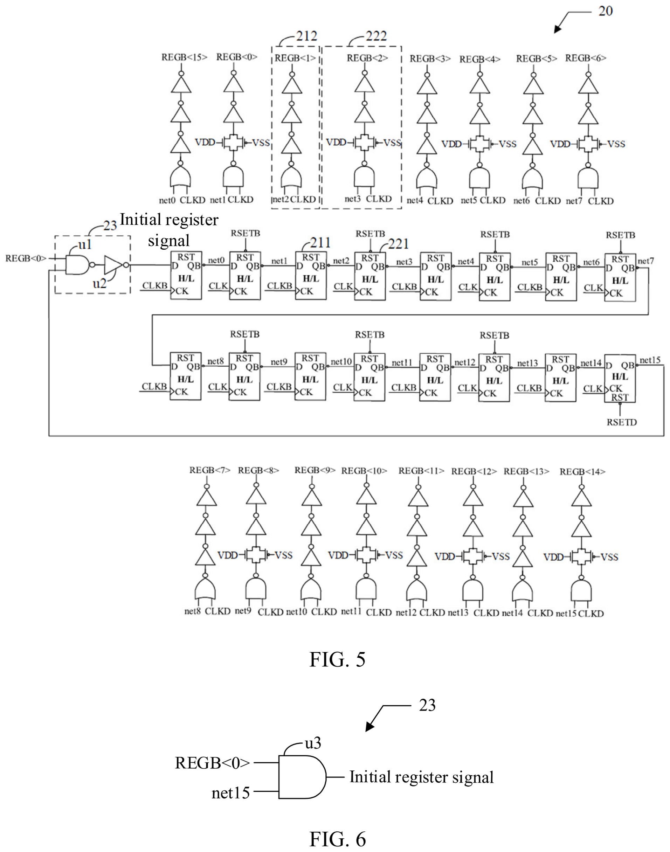

In some embodiments, FIG. 5 is a schematic diagram 2 of structural composition of a clock generation circuit according to an embodiment of the present disclosure. As shown in FIG. 5, the ith clock generation sub-circuit 21 includes the ith latch 211 and the ith first logic circuit 212, and the jth clock generation sub-circuit 22 includes the jth latch 221 and the jth second logic circuit 222.

The ith latch 211 is configured to: receive the ith register input signal and the inverted clock signal, and perform sampling processing and latching processing on the ith register input signal based on the inverted clock signal, to generate the ith register signal.

The ith first logic circuit 212 is configured to: receive the ith register signal and the delayed clock signal, and perform OR logic processing on the ith register signal and the delayed clock signal, to generate the ith target clock signal.

The jth latch 221 is configured to: receive the (j-1)th register signal and the preset clock signal, and perform sampling processing and latching processing on the (j-1)th register signal based on the preset clock signal, to generate the jth register signal.

The jth second logic circuit 222 is configured to: receive the jth register signal and the delayed clock signal, and perform NAND logic processing on the jth register signal and the delayed clock signal, to generate the jth target clock signal.

In FIG. 5, N=16 is taken as an example, but N may be any positive even number. As shown in FIG. 5, there are 16 cascaded latches. A total of eight first logic circuits 212 exist, and each are configured to perform OR logic processing on the ith register signal generated by an odd-stage latch and the delayed clock signal. A total of eight second logic circuits 222 exist, and each are configured to perform NAND logic processing on the jth register signal generated by an even-stage latch and the delayed clock signal. In addition, for ease of illustration, only reference numbers of the 3rd latch, the 3rd first logic circuit, the 4th latch, and the 4th second logic circuit are shown in FIG. 5, and reference numbers of the other clock generation sub-circuits are not shown.

Herein, a target clock signal is represented by REGB<n>, the 1st target clock signal is represented by REGB<0>, the 2nd target clock signal is represented by REGB<1>, ..., and the 16th target clock signal is represented by REGB<15>. A register signal is represented by net n, the 1st register signal is represented by net0, the 2nd register signal is represented by net1, ..., and the 16th register signal is represented by net15. The preset clock signal is represented by CLK, the inverted clock signal is represented by CLKB, and the delayed clock signal is represented by CLKD.

It should be noted that, a latch may include a clock terminal (CK), an input terminal (D), an inverting output terminal (QB), and a reset terminal (RST) herein. In addition, a set terminal (SET) may be included, but is not shown in the figure.

In some embodiments, for example, as shown in FIG. 5, the ith first logic circuit 212 includes one NOR gate and three NOT gates. A first input terminal of the NOR gate is configured to receive the ith register signal, a second input terminal of the NOR gate is configured to receive the delayed clock signal, and a signal output by the NOR gate passes through three NOT gates, to obtain the ith target clock signal.

It should be noted that the signal output by the NOR gate may also pass through an odd-numbered quantity of NOT gates such as one NOT gate, five NOT gates, or seven NOT gates, to obtain the ith target clock signal. Alternatively, the ith first logic circuit 212 may include only one OR gate. A first input terminal of the OR gate is configured to receive the ith register signal, a second input terminal of the OR gate is configured to receive the delayed clock signal, and an output terminal of the OR gate is configured to output the ith target clock signal. This is not specifically limited in this embodiment of the present disclosure.

For example, as shown in FIG. 5, the jth second logic circuit 222 includes one NAND gate, one transmission gate, and two NOT gates. A first input terminal of the NAND gate is configured to receive the jth register signal, and a second input terminal of the NAND gate is configured to receive the delayed clock signal. After a signal output by the NAND gate is transmitted by the transmission gate through driving, the signal passes through two NOT gates, to obtain the jth target clock signal.

It should be noted that the transmission gate includes one PMOS transistor and one NMOS transistor in parallel. The gate of the PMOS transistor and the gate of the NMOS transistor serve as two control terminals, and are respectively connected to a pair of mutually inverted signals. The source of the PMOS transistor and the source of the NMOS transistor are connected and serve as input terminals, and the drain of the PMOS transistor and the drain of the NMOS transistor are connected and serve as output terminals. Because the drain and the source of the PMOS transistor and the drain and the source of the NMOS transistor may be utilized interchangeably, an input terminal and an output terminal of the transmission gate may also be interchanged. As shown in FIG. 5, the gate of the PMOS transistor is configured to receive a ground signal VSS, and the gate of the NMOS transistor is configured to receive a power signal VDD.

It should be further noted that a signal output by the transmission gate may alternatively pass through an even-numbered quantity of NOT gates such as four NOT gates, six NOT gates, or eight NOT gates, to obtain the jth target clock signal. Alternatively, the jth second logic circuit 222 may include only one NAND gate, and an output terminal of the NAND gate is configured to output the jth target clock signal. This is not specifically limited in this embodiment of the present disclosure.

In a possible case, as shown in FIG. 5, the clock generation circuit 20 may further include an initial register signal generation circuit 23. The initial register signal generation circuit 23 may include a first NAND gate u1 and a seventh NOT gate u2.

A first input terminal of the first NAND gate u1 is configured to receive the 1st target clock signal, a second input terminal of the first NAND gate u1 is configured to receive the Nth register signal, an output terminal of the first NAND gate u1 is connected to an input terminal of the seventh NOT gate u2, and an output terminal of the seventh NOT gate u2 is configured to output an initial register signal.

In another possible case, as shown in FIG. 6, the first NAND gate u1 and the seventh NOT gate u2 are equivalently replaced with a first AND gate u3.

A first input terminal of the first AND gate u3 is configured to receive the 1st target clock signal, a second input terminal of the first AND gate u3 is configured to receive the Nth register signal, and an output terminal of the first AND gate u3 is configured to output an initial register signal.

In FIG. 6, N=16 is also taken as an example, and the Nth register signal is the 16th register signal net15.

In some embodiments, the jth latch 221 is further configured to: receive a reset signal, and reset, based on the reset signal, the jth register signal output by the latch.

It should be noted that, when the DRAM chip is powered on, a reset terminal of the even-stage latch is configured to receive a reset signal, and reset a correspondingly output register signal.

Further, in some embodiments, as shown in FIG. 5, the reset signal includes a first reset signal and a second reset signal.

When j<N, the jth latch 221 is configured to: receive the first reset signal, and enable, based on the first reset signal, the jth register signal output by the latch to be in a first level state.

When j=N, the Nth latch 221 is configured to: receive the second reset signal, and enable, based on the second reset signal, the Nth register signal output by the latch to be in a second level state.

Herein, the first reset signal is represented by RSETB, and the second reset signal is represented by RSETD. In addition, the first level state may be a low level state (logic "0"), and the second level state may be a high level state (logic "1").

It should be noted that, a last-stage latch sets the signal net15 to 1 based on the signal RSETD. In addition, another even-stage latch resets a signal net1, a signal net3, a signal net5, a signal net7, a signal net9, a signal net11, and a signal net13 to 0 based on the signal RSETB.

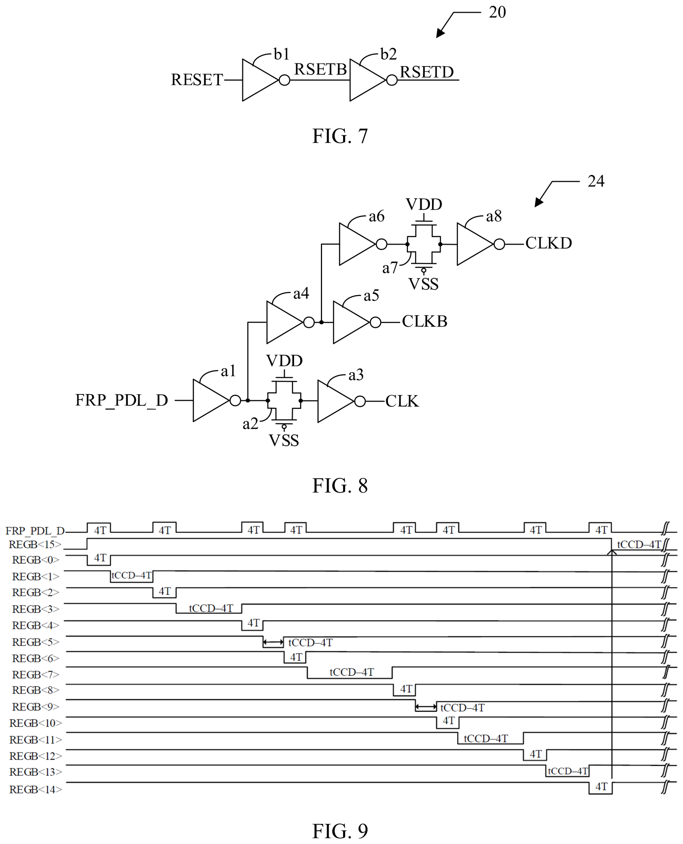

In some embodiments, as shown in FIG. 7, the first reset signal RSETB is obtained after the initial reset signal RESET is inverted by an eighth NOT gate b1; and the second reset signal RSETD is obtained after the first reset signal RSETB is inverted by a ninth NOT gate b2. In other words, the second reset signal RSETD is obtained after the initial reset signal RESET is delayed by the two NOT gates (the eighth not gate b1 and the ninth not gate b2). It may be understood that the initial reset signal RESET and the first reset signal RSETB are a pair of inverted signals, and the second reset signal RSETD is a delayed signal of the initial reset signal RESET.

In some embodiments, when the received inverted clock signal or the received preset clock signal is in the first level state, the register signal output by the latch is the register signal output by the latch before the inverted clock signal or the preset clock signal changes to the first level state; and when the received inverted clock signal or the received preset clock signal is in the second level state, the register signal output by the latch is a signal received by an input terminal of the latch.

That is, the latch in the clock generation circuit 20 is featured by high-level transmission and low-level latching (High deliver low latch). It may be understood that, when the inverted clock signal or the preset clock signal received by the latch is in a high level state, an output signal of the latch is an input signal of the latch, the latch performs a latch-through function, and the output signal changes with the input signal. When the inverted clock signal or the preset clock signal received by the latch is in a low level state, the output signal of the latch is an output signal sampled by the latch just when or before the inverted clock signal or the preset clock signal changes to the low level state. The latch performs a latch function, and the output signal does not change with the input signal.

In some embodiments, FIG. 8 is a schematic diagram of structural composition of a signal generation circuit according to an embodiment of the present disclosure. As shown in FIG. 8, the clock generation circuit 20 may further include a signal generation circuit 24.

The signal generation circuit 24 is configured to: receive an initial clock signal, and perform first delay processing on the initial clock signal, to generate the preset clock signal; perform second delay processing and inversion processing on the initial clock signal, to generate the inverted clock signal; and perform third delay processing on the initial clock signal, to generate the delayed clock signal. Duration of the first delay processing and duration of the second delay processing are the same and are both less than duration of the third delay processing, and a difference between the duration of the third delay processing and each of the duration of the first delay processing and the duration of the second delay processing is delay duration of the latch.

It should be noted that the ith latch 211 receives the inverted clock signal. The inverted clock signal is utilized to sample an input signal of the ith latch 211, to generate the ith register signal, and then OR logic processing is performed on the ith register signal and the delayed clock signal. The jth latch 221 receives the preset clock signal. The preset clock signal is utilized to sample an input signal of the jth latch 221, to generate the jth register signal, and then NAND logic processing is performed on the jth register signal and the delayed clock signal. It may be understood that when the difference between the duration of the first delay processing and the duration of the third delay processing is the delay duration of the latch, and the difference between the duration of the second delay processing and the duration of the third delay processing is the delay duration of the latch, corresponding logic processing may be exactly performed on the delayed clock signal and the signal sampled by utilizing the inverted clock signal or the preset clock signal, to meet a timing requirement.

Further, in some embodiments, as shown in FIG. 8, the signal generation circuit 24 may include a first NOT gate a1, a first transmission gate a2, a second NOT gate a3, a third NOT gate a4, a fourth NOT gate a5, a fifth NOT gate a6, a second transmission gate a7, and a sixth NOT gate a8.

An input terminal of the first NOT gate a1 is configured to receive the initial clock signal, an output terminal of the first NOT gate a1 is connected to both a first terminal of the first transmission gate a2 and an input terminal of the third NOT gate a4, a second terminal of the first transmission gate a2 is connected to an input terminal of the second NOT gate a3, and an output terminal of the second NOT gate a3 is configured to output the preset clock signal.

An output terminal of the third NOT gate a4 is connected to both an input terminal of the fourth NOT gate a5 and an input terminal of the fifth NOT gate a6, and an output terminal of the fourth NOT gate a5 is configured to output the inverted clock signal.

An output terminal of the fifth NOT gate a6 is connected to a first terminal of the second transmission gate a7, a second terminal of the second transmission gate a7 is connected to an input terminal of the sixth NOT gate a8, and an output terminal of the sixth NOT gate a8 is configured to output the delayed clock signal.

Herein, the initial clock signal is represented by FRP_PDL_D.

As shown in FIG. 8, the first transmission gate a2 and the second transmission gate a7 each include one PMOS transistor and one NMOS transistor in parallel, the gate of the PMOS transistor is configured to receive a ground signal VSS, and the gate of the NMOS transistor is configured to receive a power signal VDD. In addition, in this embodiment of the present disclosure, the first terminal is an input terminal, and the second terminal is an output terminal.

It may be understood that first delay processing is performed on the signal FRP_PDL_D through the first NOT gate a1, the first transmission gate a2, and the second NOT gate a3, to generate a signal CLK; second delay processing and inversion processing are performed on the signal FRP_PDL_D through the first NOT gate a1, the third NOT gate a4, and the fourth NOT gate a5, to generate a signal CLKB; and third delay processing is performed on the signal FRP_PDL_D through the first NOT gate a1, the third NOT gate a4, the fifth NOT gate a6, the second transmission gate a7, and the sixth NOT gate a8, to generate a signal CLKD.

Because the signal CLK is obtained after the signal FRP_PDL_D passes through two NOT gates and one transmission gate (the first NOT gate a1, the first transmission gate a2, and the second NOT gate a3), the signal CLKB is obtained after the signal FRP_PDL_D passes through three NOT gates (the first NOT gate a1, the third NOT gate a4, and the fourth NOT gate a5), and the transmission gate and the NOT gate each include one PMOS transistor and one NMOS transistor, the duration of the first delay processing and the duration of the second delay processing are the same.

It should be noted that a special design is utilized for a clock signal generated based on the signal FRP_PDL_D. Both the signal CLK and the signal CLKB are from the signal FRP_PDL_D plus three stages of logic gates (Gate). Specifically, the signal CLK is the signal FRP_PDL_D plus a total of three stages of logic gates: the first NOT gate a1, the first transmission gate a2, and the second NOT gate a3; the signal CLKB is the signal FRP_PDL_D plus a total of three stages of logic gates: the first NOT gate a1, the third NOT gate a4, and the fourth NOT gate a5; and the signal CLKD is the signal FRP_PDL_D plus a total of five stages of logic gates: the first NOT gate a1, the third NOT gate a4, the fifth NOT gate a6, the second transmission gate a7, and the sixth NOT gate a8. In addition, because each latch includes two stages of logic gates, and both the signal CLKD and the signals net0 to net15 are finally the signal FRP_PDL_D plus delay duration of the five stages of logic gates, to avoid a glitch (glitch) when OR logic processing or NAND logic processing is performed on the signals net0 to net15 and the signal CLKD, thereby meeting a timing requirement.

In some embodiments, the ith target clock signal is configured to control timing of writing first data, the jth target clock signal is configured to control timing of writing second data, the first data is 1 bit of data in 2 bits of data transmitted on a data bus, and the second data is the other bit of data in the 2 bits of data transmitted on the data bus.

It should be noted that, in this embodiment of the present disclosure, the generated target clock signal is configured to control timing of writing the double data, and the double data is 2 bits of data transmitted through one data bus, which are first data and second data. Herein, the odd-stage clock generation sub-circuit generates one group of target clock signals, to control timing of writing the first data, and the even-stage clock generation sub-circuit generates one group of target clock signals, to control timing of writing the second data.

Further, in some embodiments, an active level time of the ith target clock signal is first duration, and an active level time of the jth target clock signal is second duration.

The sum of the first duration and the second duration meets a time interval between a column address strobe command and a next column address strobe command.

It should be noted that the sum of the first duration and the second duration is tCCD. The first duration may be 4T, the second duration may be tCCD-4T, and T is a clock cycle of a system clock signal. However, this is not specifically limited.

It should be further noted that when a data window of the first data in the double data is 4T, the first duration is also 4T, which may match the data window of the first data, and meets timing of writing the first data. When a data window of the second data in the double data is tCCD-4T, the second duration is also tCCD-4T, which may match the data window of the second data, and meets timing of writing the second data.

In some embodiments, the initial clock signal is generated based on a read command, and one read command corresponds to a pulse whose pulse length is the first duration and whose level state is the second level state in the initial clock signal.

It may be understood that each time the DRAM receives one read command, a high level pulse whose pulse length is 4T is generated based on the signal FRP_PDL_D.

First delay processing is performed on the signal FRP_PDL_D, to generate the signal CLK. In other words, the signal CLK derives from a signal FRP_PDL_D whose pulse length is 4T. Because the signal FRP_PDL_D is at a low level by default, and a high level pulse whose pulse length is 4T is generated only when the DRAM receives one read command, the signal CLK is at a low level by default. The signal CLKB and the signal CLK are a pair of inverted signals, and the signal CLKB is at a high level by default. The signal CLKD is the delayed signal of the signal CLK. The signal CLKD is at a low level by default.

FIG. 9 is a schematic diagram 1 of timing of a clock generation circuit according to an embodiment of the present disclosure. When the DRAM chip is powered on, the ne15 signal is set to 1, the net1 signal, the net3 signal, the net5 signal, the net7 signal, the net9 signal, the net11 signal, and the net13 signal are reset to 0, the latch is featured by high-level transmission and low-level latching, and the latch is an inverting output terminal. Therefore, when the whole circuit is in an initial state, level states of the signals net0 to net15 are 0010101010101011. Because the net1 signal is at a low level, NAND logic processing is performed on the net1 signal and the signal CLKD. As shown in FIG. 9, the obtained signal REGB<0> is at a high level. Because the signal REGB<0> is at a high level, the net15 signal is at a high level, and the initial register signal obtained through the first NAND gate u1 and the seventh NOT gate u2 is at a high level, that is, a signal received at an input terminal of the 1st latch is at a high level, the net0 signal is a low level. In this way, OR logic processing is performed on the net0 signal and the signal CLKD, and the obtained signal REGB<15> is at a low level. Similarly, all signals REGB<0 to 14> (combined writing of REGB<0> to REGB<14>) are at a high level.

When a high level pulse whose pulse length is 4T in the signal FRP_PDL_D arrives, the signal CLK is at a high level, the signal CLKB is at a low level, and the signal CLKD is at a high level. Through actions of all latches, when a high level pulse whose pulse length is 4T arrives in the whole circuit, the level states of the signals net0 to net15 change to 0110101010101010. OR logic processing or NAND logic processing is performed on the signal CLKD and each of the signals net0 to net15. As shown in FIG. 9, the obtained signal REGB<0> changes to a low level, and all signals REGB<1 to 15> (combined writing of REGB<1> to REGB<15>) are at a high level.

Then, when the high level pulse whose pulse length is 4T in the signal FRP_PDL_D ends, the signal CLK is at a low level again, the signal CLKB is at a high level, and the signal CLKD is at a low level. Through actions of all latches, when the high level pulse whose pulse length is 4T ends in the whole circuit, the level states of the signals net0 to net15 change to 1100101010101010. As shown in FIG. 9, in this case, the signal REGB<0> changes to a high level, REGB<1> changes to a low level, and all signals REGB<2 to 15> (combined writing of REGB<2> to REGB<15>) are at a high level. Then, when a next read command arrives, the same is true. Details are not described herein again.

In conclusion, the clock generation circuit 20 may be considered as a shift register, and the signal CLK derives from the signal FRP_PDL_D whose pulse length is 4T. When the DRAM chip is powered on, the shift register is reset, both the signal REGB<0> and the net15 signal are 1, an initial register signal received at an input terminal of the 1st latch is at a high level, and the latch in the clock generation circuit 20 is featured by high-level transmission and low-level latching. Therefore, the net0 signal is 0 after the shift register is reset. Then, when each read command arrives, a high level pulse whose pulse length is 4T is generated in the signal FRP_PDL_D. In this period, a potential of the net1 signal changes to 1, and level state duration in which the net1 signal is 1 is also 4T. Then, NAND logic processing is performed on the net1 signal and the signal CLKD whose pulse length is 4T. Finally, a low level pulse whose pulse length is 4T is generated in the signal REGB<0>. When the signal FRP_PDL_D returns to a low level, the signal CLKB is at a high level, a high level of the net1 signal continues to shift to a low level of the net2 signal, OR logic processing is performed on the net2 signal and the signal CLKD, and the signal REGB<1> changes to a low level. This continues until a next read command arrives. To be specific, when the high level pulse whose pulse length is 4T in the signal FRP_PDL_D arrives, the foregoing shift processing continues to be performed. That is, the clock generation circuit 20 converts the high level pulse of 4T in the input signal FRP_PDL_D into two pulses through the latch and the logic circuit. For example, the signal REGB<0> and the signal REGB<1> are generated from a high level pulse of 4T in one signal FRP_PDL_D.

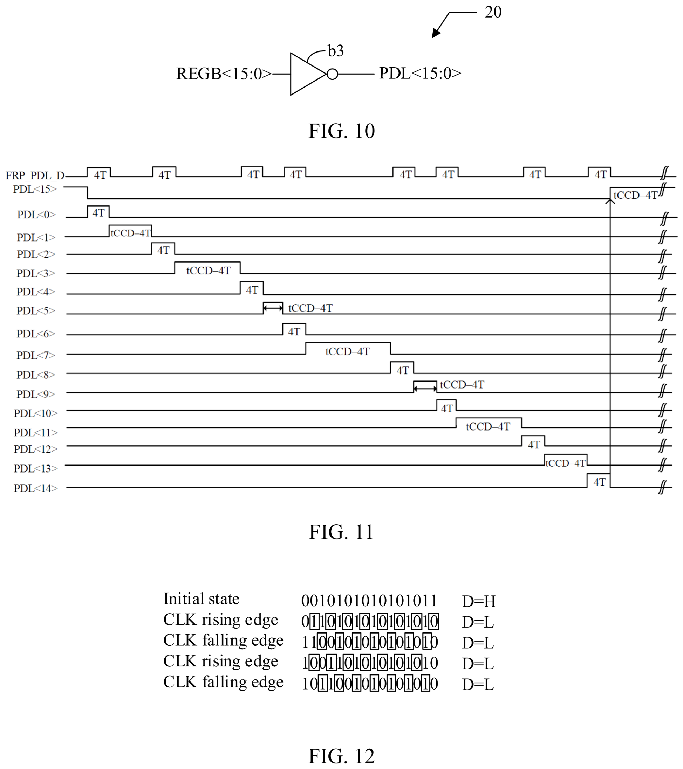

As shown in FIG. 10, signals REGB<15:0> (combined writing of REGB<0> to REGB<15>) are inverted by the tenth NOT gate b3, to obtain signals PDL<15:0> (combined writing of PDL<0> to PDL<15>), and finally, the double data is written into the FIFO structure based on the signals PDL<15:0>. A waveform of the signals PDL<15:0> is the inverse of the signals REGB<15:0>, and a sequence of the signals PDL<15:0> is shown in FIG. 11.

In a circuit design of the clock generation circuit 20, an odd-stage latch may be considered as one group of shift components, and acts on a rising edge of the signal CLK; and an even-stage latch is considered as one group of shift components, and acts on a falling edge of the signal CLK. The odd-stage latches form shifts of the signal PDL<0>, the signal PDL<2>, ..., and the signal PDL<14> in FIG. 11. The even-stage latches form shifts of the signal PDL<1>, the signal PDL<3>, ..., and the signal PDL<13> in FIG. 11.

FIG. 12 is a schematic diagram of timing analysis of a clock generation circuit according to an embodiment of the present disclosure. As shown in FIG. 12, 16 digits respectively represent the level states of the signals net0 to net15, and D represents a level state of the net15 signal. The initial state (Initial) is the level states of the signals net0 to net15 when the DRAM chip is powered on. When 1 is in a box of a CLK rising edge (rising), a signal PDL correspondingly generated for this bit is at a high level; and when 0 is in a box of a CLK falling edge (falling), a signal PDL correspondingly generated for this bit is at a high level.

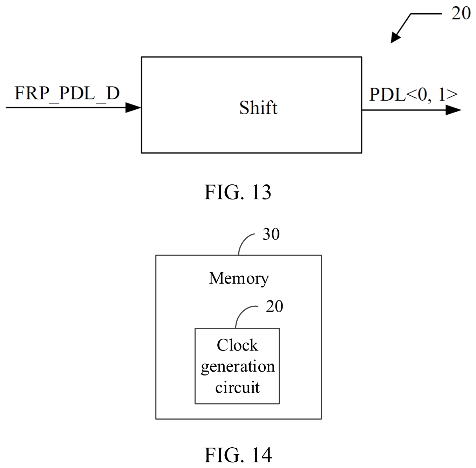

Based on the clock generation circuit 20 in the foregoing embodiments, FIG. 13 is a schematic diagram 5 of structural composition of a clock generation circuit according to an embodiment of the present disclosure. As shown in FIG. 13, only one group of shift circuits (Shift) are utilized in a clock generation circuit 20. A signal PDL is obtained based on a signal FRP_PDL_D through a latch and a logic circuit in the shift circuit, to write double data, thereby saving circuit resources, and ensuring a timing condition in which a signal PDL<1> starts only after a signal PDL<0> ends.

In another embodiment of the present disclosure, FIG. 14 is a schematic diagram of structural composition of a memory according to an embodiment of the present disclosure. As shown in FIG. 14, a memory 30 may include the clock generation circuit 20 in any one of the foregoing embodiments.

The memory 30 may be an SRAM, a DRAM, an SDRAM, a DDR SDRAM, or the like. This is not specifically limited.

Further, in some embodiments, the memory 30 may include a DRAM chip. The DRAM chip may not only meet a memory specification such as DDR, DDR2, DDR3, DDR4, DDR5, and DDR6, but also meet a memory specification such as LPDDR, LPDDR2, LPDDR3, LPDDR4, LPDDR5, and LPDDR6. This is not specifically limited herein.

In this embodiment of the present disclosure, for the memory 30, two groups of target clock signals may be obtained through only one clock generation circuit 20, thereby saving circuit resources.

The foregoing descriptions are merely example embodiments of the present disclosure, and are not intended to limit the protection scope of the present disclosure.

It should be noted that in the present disclosure, the terms "include", "comprise", or any other variant thereof are intended to cover non-exclusive inclusion, so that a procedure, method, article, or apparatus that includes a series of elements includes not only those elements but also other elements that are not expressly listed, or further includes elements inherent to such a procedure, method, article, or apparatus. An element preceded by "includes a ..." does not, without more constraints, preclude the presence of additional identical elements in the process, method, article, or apparatus including the element.

The sequence numbers of the foregoing embodiments of the present disclosure are merely for the purpose of description, and are not intended to indicate priorities of the embodiments.

The methods disclosed in the several method embodiments provided in the present disclosure may be randomly combined when there is no conflict, to obtain new method embodiments.

The features disclosed in the several product embodiments provided in the present disclosure may be randomly combined when there is no conflict, to obtain new product embodiments.

The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A clock generation circuit (20), the clock generation circuit being configured to generate N target clock signals, N being a positive even number, and the clock generation circuit comprising N clock generation sub-circuits;
an ith clock generation sub-circuit (21) being configured to: receive an ith register input signal, an inverted clock signal (CLKB), and a delayed clock signal (CLKD); perform sampling processing and latching processing on the ith register input signal based on the inverted clock signal, to generate an ith register signal; and perform first logic processing on the ith register signal and the delayed clock signal, to generate an ith target clock signal, i being a positive odd number greater than or equal to 1 and less than N, the ith register input signal being an initial register signal when i=1, and the ith register input signal being an (i-1)th register signal when i>1;
a jth clock generation sub-circuit (22) being configured to: receive a (j-1)th register signal, a preset clock signal (CLK), and the delayed clock signal; perform sampling processing and latching processing on the (j-1)th register signal based on the preset clock signal, to generate a jth register signal; and perform second logic processing on the jth register signal and the delayed clock signal, to generate a jth target clock signal, j being a positive even number greater than 1 and less than or equal to N; and
the preset clock signal and the inverted clock signal being a pair of inverted signals, and the delayed clock signal being a delayed signal of the preset clock signal.

2. The clock generation circuit according to claim 1, wherein the first logic processing is OR logic processing, and the second logic processing is NAND logic processing.

3. The clock generation circuit according to claim 2, wherein the ith clock generation sub-circuit comprises an ith latch (211) and an ith first logic circuit (212), and the jth clock generation sub-circuit comprises a jth latch (221) and a jth second logic circuit (222);
the ith latch is configured to: receive the ith register input signal and the inverted clock signal, and perform sampling processing and latching processing on the ith register input signal based on the inverted clock signal, to generate the ith register signal;
the ith first logic circuit is configured to: receive the ith register signal and the delayed clock signal, and perform OR logic processing on the ith register signal and the delayed clock signal, to generate the ith target clock signal;
the jth latch is configured to: receive the (j-1)th register signal and the preset clock signal, and perform sampling processing and latching processing on the (j-1)th register signal based on the preset clock signal, to generate the jth register signal; and
the jth second logic circuit is configured to: receive the jth register signal and the delayed clock signal, and perform NAND logic processing on the jth register signal and the delayed clock signal, to generate the jth target clock signal.

4. The clock generation circuit according to any one of claims 1 to 3, the clock generation circuit further comprising a first AND gate (u3); and
a first input terminal of the first AND gate being configured to receive a 1st target clock signal, a second input terminal of the first AND gate being configured to receive an Nth register signal, and an output terminal of the first AND gate being configured to output the initial register signal.

5. The clock generation circuit according to claim 3 or 4, wherein
the jth latch is further configured to: receive a reset signal, and reset, based on the reset signal, the jth register signal output by the latch.

6. The clock generation circuit according to claim 5, wherein the reset signal comprises a first reset signal (RSETB) and a second reset signal (RSETD);
when j<N, the jth latch is configured to: receive the first reset signal, and enable, based on the first reset signal, the jth register signal output by the latch to be in a first level state; and
when j=N, an Nth latch is configured to: receive the second reset signal, and enable, based on the second reset signal, the Nth register signal output by the latch to be in a second level state.

7. The clock generation circuit according to claim 6, wherein
when the received inverted clock signal or the received preset clock signal is in the first level state, the register signal output by the latch is a register signal output by the latch before the inverted clock signal or the preset clock signal changes to the first level state; and when the received inverted clock signal or the received preset clock signal is in the second level state, the register signal output by the latch is a signal received by an input terminal of the latch.

8. The clock generation circuit according to any one of claims 3 to 7, the clock generation circuit further comprising a signal generation circuit (24); and
the signal generation circuit being configured to: receive an initial clock signal (FRP_PDL_D), and perform first delay processing on the initial clock signal, to generate the preset clock signal; perform second delay processing and inversion processing on the initial clock signal, to generate the inverted clock signal; and perform third delay processing on the initial clock signal, to generate the delayed clock signal, duration of the first delay processing and duration of the second delay processing being the same and being both less than duration of the third delay processing, and a difference between the duration of the third delay processing and each of the duration of the first delay processing and the duration of the second delay processing being delay duration of the latch.

9. The clock generation circuit according to claim 8, wherein the signal generation circuit comprises a first NOT gate (a1), a first transmission gate (a2), a second NOT gate (a3), a third NOT gate (a4), a fourth NOT gate (a5), a fifth NOT gate (a6), a second transmission gate (a7), and a sixth NOT gate (a8);
an input terminal of the first NOT gate is configured to receive the initial clock signal, an output terminal of the first NOT gate is connected to both a first terminal of the first transmission gate and an input terminal of the third NOT gate, a second terminal of the first transmission gate is connected to an input terminal of the second NOT gate, and an output terminal of the second NOT gate is configured to output the preset clock signal;
an output terminal of the third NOT gate is connected to both an input terminal of the fourth NOT gate and an input terminal of the fifth NOT gate, and an output terminal of the fourth NOT gate is configured to output the inverted clock signal; and
an output terminal of the fifth NOT gate is connected to a first terminal of the second transmission gate, a second terminal of the second transmission gate is connected to an input terminal of the sixth NOT gate, and an output terminal of the sixth NOT gate is configured to output the delayed clock signal.

10. The clock generation circuit according to claim 8 or 9, wherein the ith target clock signal is configured to control timing of writing first data, the jth target clock signal is configured to control timing of writing second data, the first data is 1 bit of data in 2 bits of data transmitted on a data bus, and the second data is the other bit of data in the 2 bits of data transmitted on the data bus.

11. The clock generation circuit according to claim 10, wherein an active level time of the ith target clock signal is first duration, and an active level time of the jth target clock signal is second duration; and
a sum of the first duration and the second duration meets a time interval between a column address strobe command and a next column address strobe command.

12. The clock generation circuit according to claim 11, wherein
the initial clock signal is generated based on a read command, and one read command corresponds to a pulse whose pulse length is the first duration and whose level state is the second level state in the initial clock signal.

13. A memory (30), the memory comprising the clock generation circuit (20) according to any one of claims 1 to 12.
